# EUROPÄISCHE PATENTSCHRIFT

(11) **EP 1 075 642 B1**
(45) Veröffentlichungstag und Bekanntmachung des Hinweises auf die Patenterteilung: **25.06.2003**
(21) Anmeldenummer: 99927672.8
(22) Anmeldetag: 16.04.1999
(51) Int. Cl.: G01B 11/02, G02B 21/08, H01L 21/66

(54) **Lagekoordinaten-Messgerät zur Vermessung von Strukturen auf einem transparenten Substrat**
Position coordinate measuring device for measuring structures on a transparent substrate
Appareil de mesure de cordonnées de position pour la mesure de structures sur un substrat transparent

(30) Priorität: 30.04.1998 DE 19819492
(43) Veröffentlichungstag der Anmeldung: 14.02.2001
(73) Patentinhaber: Leica Microsystems Wetzlar GmbH, 35530 Wetzlar (DE)
(72) Erfinder: BLÄSING-BANGERT, Carola, D-35625 Hüttenberg (DE); RINN, Klaus, D-35452 Heuchelheim (DE); KACZYNSKI, Ulrich, D-61231 Bad Nauheim (DE); BECK, Mathias, CH-1290 Versoix (CH)
(74) Vertreter: Reichert, Werner F., Dr.
(86) Internationale Anmeldenummer: DE9901141
(87) Internationale Veröffentlichungsnummer: WO99057508

(56) Entgegenhaltungen:
- DE-A- 3 514 459
- DE-B- 1 263 339
- US-A- 5 260 558
- W.MIRAND : "Kantenvermessung an Mikrostrukturen" VDI-BERICHTE, Nr. 1102, 1993, XP002117581 in der Anmeldung erwähnt
- ROTH K -D ET AL: "Performance data obtained on a new mask metrology tool" 16TH ANNUAL SYMPOSIUM ON PHOTOMASK TECHNOLOGY AND MANAGEMENT, REDWOOD CITY, CA, USA, 18-20 SEPT. 1996, Bd. 2884, Seiten 360-366, XP002117582 Proceedings of the SPIE - The International Society for Optical Engineering, 1996, SPIE-Int. Soc. Opt. Eng, USA ISSN: 0277-786X

## Beschreibung

Die Erfindung betrifft ein Lagekoordination-Meßgerät und ein Verfahren zur Bestimmung der Lage von Strukturen auf einem transparenten Substrat, wobei die Lage durch den Abstand einer Kante der Struktur relativ zu einem Bezugspunkt definiert ist, mit einer Auflicht-Beleuchtungseinrichtung, einer Abbildungs-Einrichtung und einer Detektor-Einrichtung für die abgebildeten Strukturen und einem senkrecht und relativ zur optischen Achse der Abbildungs-Einrichtung interferometrisch meßbar verschiebbarem Meßtisch zur Aufnahme des Substrats.

Ein Meßgerät dieser Art ist z.B. in dem Vortragsmanuskript: Pattern Placement Metrology for Mask Making, Dr. Carola Bläsing, ausgegeben anläßlich der Tagung Semicon, Education Program, in Genf am 31.03.1998, ausführlich beschrieben. Das Meßgerät ist in einer Klimakammer aufgestellt, um eine Meßgenauigkeit im Nanometer-Bereich erreichen zu können. Gemessen werden die Koordinaten von Strukturen auf Masken und Wafern. Das Meßsystem ist auf einem schwingungsgedämpft gelagerten Granitblock angeordnet. Die Masken und Wafer werden mit einem automatischen Handlingsystem auf den Meßtisch gebracht.

Der Meßtisch gleitet auf Luftlagern auf der Oberfläche des Granitblocks. An zwei zueinander senkrecht stehenden Seiten des Meßtisches sind ebene Spiegel angebracht. Ein Laser-Interferometer-System bestimmt die Position des Meßtisches.

Die Beleuchtung und die Abbildung der zu messenden Strukturen erfolgt über eine hoch auflösende, apo-chromatisch korrigierte Mikroskop-Optik im Auflicht im Spektralbereich des nahen UV. Eine CCD-Kamera dient als Detektor. Aus den innerhalb eines Meßfensters liegenden Pixeln des Detektorarrays werden Meßsignale gewonnen. Durch Bildverarbeitung wird daraus ein Intensitätsprofil der gemessenen Struktur abgeleitet, aus dem z. B. die Kantenlage der Struktur ermittelt wird.

Das beschriebene Meßgerät wird vorzugsweise zur Bestimmung der Kantenlage von Strukturen auf Masken und Wafern für die Halbleiterherstellung verwendet. Die Strukturen werden durch Schichten gebildet, die auf die Maskenfläche aufgebracht sind. Die Oberflächen sind unterschiedlich reflektierend. Die Kanten dieser Schichten sind aufgrund des Herstellungsprozesses unterschiedlich steil und unterschiedlich sauber ausgebildet. Ein TV-Autofokussystem sucht zur Optimierung der Abbildung der Kante die Einstellung mit dem schärfsten Kontrast. Die in dieser Einstellung gemessene Lage der Kante relativ zur optischen Achse des Abbildungssystems in Verbindung mit der gemessenen Tischposition ergibt die Lagekoordinate des Strukturelementes im Maschinen-Koordinatensystem. Dieses läßt sich nach vorheriger Ausrichtung der Maske in ein Masken-Koordinatensystem umrechnen und mit den Designdaten der Strukturelemente vergleichen. Bei z. B. linienförmigen Strukturelementen können auch beide Kantenlagen gemessen werden. Die Mittellinie dazu kann dann als Lagekoordinate gewählt werden. Bei kreuzförmigen Strukturen kann der Schnittpunkt der Mittellinien als Position angegeben werden.

Die gemessene Kantenlage hängt zum einen von der physikalischen Qualität der Kante selbst und zum anderen von der verwendeten optischen Meßmethode sowie der Güte des Abbildungssystems ab. Die Zusammenhänge werden in dem Aufsatz "Kantenvermessung an Mikrostrukturen", W. Mirandé, VDI Berichte Nr. 1102 (1993), Seite 137 ff, beschrieben.

Bei der Kantenvermessung handelt es sich um eine Information über die Geometrie und Form der Kante selbst. Die in dem Aufsatz geschilderten lichtoptischen Verfahren arbeiten im Auflicht und im Durchlicht. Aus DE 35 14 459 A1 ist dazu ein Verfahren bekannt, bei dem beide Meßverfahren miteinander kombiniert und der Kantenort durch den Schnittpunkt der im Auflicht und Durchlicht erhaltenen Intensitätsverteilungen bei der Abtastung des Kantenprofils definiert wird. Aus benachbarten Kantenorten eines Strukturelementes werden lokale Strukturbreiten ermittelt. Die bekannten Geräte zur Strukturbreitenmessung sind grundsätzlich nicht dafür ausgelegt, die Kantenlage relativ zu einem für alle Strukturelemente festgelegten Bezugspunkt mit derselben Genauigkeit zu bestimmen wie den Kantenort selbst.

Wird die Position der Struktur durch die Mittellinie zu den beiden Kanten definiert, so haben die Einflüsse auf die gemessene Kantenlage im allgemeinen keine Auswirkung auf die gemessene Position der Struktur. Die Auswertung der Meßergebnisse für eine Strukturbreitenmessung kann dagegen in unterschiedlichen Meßgeräten zu unterschiedlichen Ergebnissen führen.

Bei der Halbleiterherstellung wird die Maske im Stepper im Durchlicht beleuchtet und auf den Wafer abgebildet. Es besteht daher auch ein Interesse daran, die genaue licht-abschattende Breite des Strukturelementes ermitteln zu können. Hierfür wurden spezielle Meß-Mikroskope entwickelt, bei denen die Maske im Durchlicht beleuchtet und ausschließlich die Breite des opaken Strukturbildes gemessen wird. Für eine Bestimmung der Lagekoordinaten der Strukturelemente sind diese Meßgeräte nicht vorgesehen. Diese Überlegungen gelten in gleicher Weise, wenn anstelle opaker Strukturelemente transparente Strukturelemente in der Maskenoberfläche gemessen werden sollen.

Die zunehmenden Anforderungen in der Qualitätskontrolle der Maskenherstellung erfordern eine Überprüfung der Designparameter der Maskenstrukturen sowohl hinsichtlich ihrer Lage als auch ihrer wirksamen Projektionsbreite. Dabei wird eine immer kürzere Durchlaufzeit gefordert. Die notwendigen Reinheitsanforderungen bedingen zudem eine steigende Sorgfalt bei den Handlingvorgängen für die Auflage der Maske im Meßgerät. Bei zunehmender Größe der Masken und steigender Strukturdichte nimmt auch der Wert der Masken nach jedem Prozeßschritt zu, so daß auch die Sicherheit des Handlings gegen Zerstörung der Masken von entscheidender Bedeutung ist.

Der Erfindung lag daher die Aufgabe zugrunde, ein Meßgerät zu schaffen, mit dem sowohl eine genaue Lagebestimmung als auch eine zuverlässigere Aussage über die Strukturbreite ohne Kenntnis der geometrischen Kantenprofile möglich ist.

Diese Aufgabe wird nach Anspruch 1 oder nach Anspruch 4 gelöst. Vorteilhafte Weiterbildungen ergeben sich aus den Merkmalen der Unteransprüche.

Mit der erfindungsgemäßen Ausgestaltung des an sich bekannten Meßgerätes wird es möglich, mit nur einem Handlingvorgang in demselben Meßgerät sowohl die Lagekoordinaten als auch die Strukturbreite in Auflicht- und Durchlicht-Beleuchtung zu messen. Der Wegfall von Rüstzeiten für die Einbringung in ein zweites Meßgerät und auch von Meßzeiten beschleunigt die Qualitätskontrolle. Die Einsparung eines zusätzlichen Meßgerätes verbilligt die Kontrolle, vereinfacht die Einbindung des Kontroll-Meßgerätes in eine Prozeßlinie und verringert die Gefahr einer Zerstörung des Substrats beim Handling. Der unmittelbare Vergleich von Meßwerten bei unterschiedlichen Beleuchtungen unter sonst gleichen Auswertebedingungen ermöglicht eine erweiterte Analyse der Maskenherstellungsprozesse.

In überraschender Weise hat es sich herausgestellt, daß auch mit dem als Rahmen ausgebildeten Meßtisch die Meßgenauigkeit des Meßgerätes für die Messung der Lagekoordinaten beibehalten werden kann. Die Strukturbreite kann somit aufgrund der Durchlicht-Beleuchtung mit derselben Genauigkeit gemessen werden wie die der Lagekoordinaten und die Strukturbreite kann einer genau bestimmten Lage auf der Maske zugeordnet werden. Der Vergleich der Meßwerte für die Kantenlage im Auflicht und Durchlicht ergibt zusätzliche Informationen über die Ausbildung der Kante. Auf diese Weise können insbesondere auch unsymmetrische Kantenprofile erkannt und zur Korrektur der Positions-Koordinaten der Strukturelemente verwendet werden.

In der Zeichnung ist ein Ausführungsbeispiel des erfindungsgemäßen Meßgerätes schematisch dargestellt und wird anhand der Figuren nachfolgend beschrieben. Dabei zeigen
- Fig. 1: eine Ansichtsdarstellung des Meßgerätes und
- Fig. 2: ein Struktur- und Intensitätsprofil mit Auswertung im Auflicht und Durchlicht
- Fig. 3: ein anderes Struktur- und Intensitätsprofil

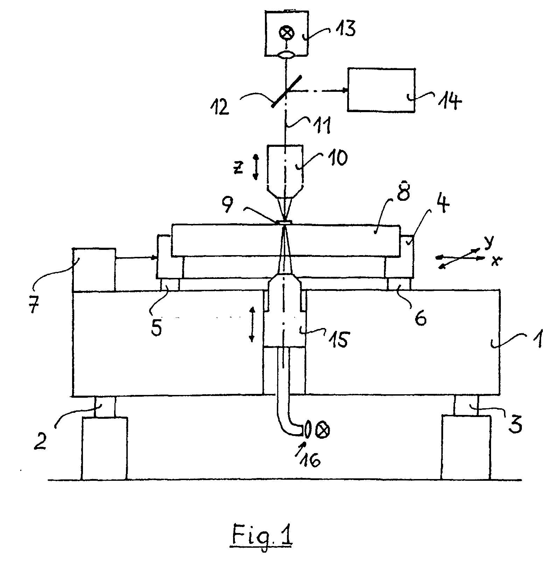

Das in Fig. 1 dargestellte Ausführungsbeispiel besteht aus einem Granitblock 1, der auf Füßen 2, 3 schwingungsgedämpft gelagert ist. Auf dem Granitblock 1 ist ein als Rahmen ausgebildeter Meßtisch 4 auf Luftlagern 5, 6 in den zwei durch Pfeile angedeuteten Richtungen gleitend verschiebbar. Der Rahmen des Meßtisches 4 besteht vorteilhafterweise aus einer Glaskeramik mit geringem thermischen Ausdehnungskoeffizienten. Die Antriebe dafür sind nicht dargestellt. Die Position des Meßtisches 4 wird mit einem Laser-Interferometer-System 7 in x- und y-Richtung gemessen.

In den Rahmen des Meßtisches 4 ist eine Maske 8 eingelegt. Die Maske 8 besteht z.B. aus Quarzglas. Auf der Maskenoberfläche sind Strukturen 9 aufgebracht. Da der Meßtisch 4 als Rahmen ausgebildet ist, kann die Maske 8 auch von unten her durchleuchtet werden.

Oberhalb der Maske 8 befindet sich ein Abbildungssystem 10 hoher optischer Güte, das zur Fokussierung längs seiner optischen Achse 11 in z-Richtung verstellbar ist. Über einen Teilerspiegel 12 wird zum einen das Licht einer Lichtquelle 13 in den optischen Strahlengang eingeleitet und zum anderen werden die Abbildungsstrahlen auf eine Detektor-Einrichtung 14 gelenkt. Die Detektor-Einrichtung 14 ist z.B. eine CCD-Kamera mit hochauflösendem Pixelarray. Die Lichtquelle 13 emittiert im nahen UV-Spektralbereich.

In den Granitblock 1 ist eine weitere Beleuchtungseinrichtung eingesetzt, die aus einem höhenverstellbaren Kondensor 15 und einer Lichtquelle 16 besteht. Als Lichtquelle 16 kann auch die Austrittsfläche eines Lichtleiters vorgesehen sein. Die optische Achse des Kondensors 15 fluchtet mit der optischen Achse 11 des Abbildungssystems 10. Die Höhenverstellung des Kondensors 15 mit Lichtquelle 16 dient der Anpassung der auf die Struktur 9 zu richtenden Beleuchtungsstrahlen an unterschiedliche optische Dicken von Masken 8. Der Kondensorkopf kann insbesondere in den offenen Teil des Meßtischrahmens hineinreichen. Zum Schutz vor Beschädigungen bei Tischverschiebungen über die gesamte Maskenfläche kann er aber auch unter die Oberfläche des Granitblocks gezogen werden. Die Lichtquellen 13 und 16 sind voneinander unabhängig einschaltbar.

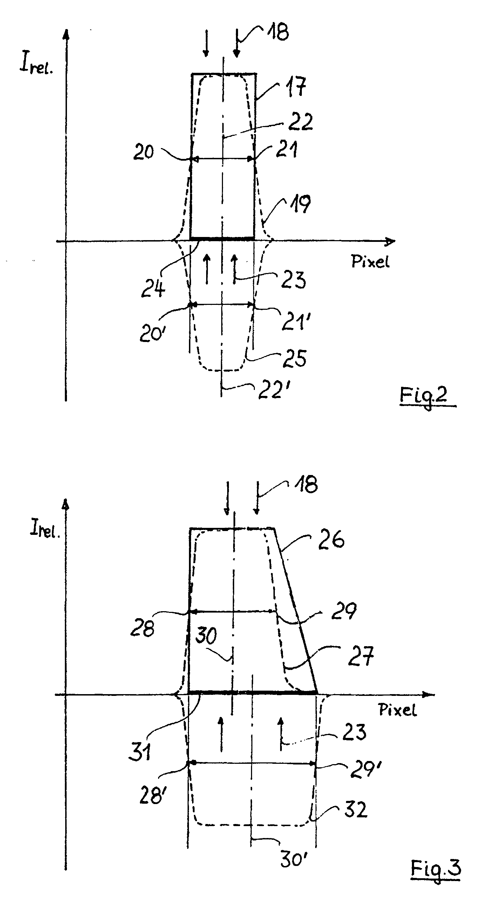

In Fig. 2 ist als ausgezogenes Rechteck ein Querschnitt durch ein ideales Strukturelement 17 dargestellt. Die Strukturhöhe beträgt etwa 100-200 nm. Wird ein solches Strukturelement 17 im Auflicht 18 beleuchtet und auf die Pixel der CCD-Empfängerfläche der Kamera 14 abgebildet, so ist auch bei optimaler Fokussierung das Bild im Kantenbereich beugungsbedingt unscharf. Das Beugungsscheibchen jedes Bildpunktes ist dabei größer als ein Pixelelement. Ein quer zu den Kanten aus den Pixelintensitäten der CCD-Elemente abgeleitetes relatives Intensitätsprofil 19 hat schematisch den nach oben gestrichelt eingezeichneten Verlauf. Aus theoretischen Überlegungen ergibt sich, daß mit 50 % der Intensität die Lage der Kante 20, 21 des Strukturelementes 17 am besten wiedergegeben wird. Die Mittellinie 22 zu den auf diese Weise bestimmten Kantenlagen 20, 21 definiert die Lagekoordinate des Strukturelementes 17.

Wird dasselbe Strukturelement 17 im Durchlicht 23 beleuchtet, so erscheint es für die abbildende Optik 10 als dunkler Schatten 24. Auch hier werden die Schattengrenzen mehr oder weniger scharf auf die CCD-Elemente abgebildet. Es ergibt sich in gleicher Weise ein relatives Intensitätsprofil 25, das nach unten aufgetragen ist. Definiert man die Lage der Kante wiederum über das 50 %-Niveau des Intensitätsprofils, so ergibt sich in diesem Idealfall dieselbe Kantenlage 20', 21' wie im Auflicht 18 und auch dieselbe Lagekoordinate 22'. Für die durch Pfeile zwischen den Kanten angedeutete Strukturbreite ergibt sich ebenfalls derselbe Wert aus der Differenz der beiden Kantenlagen 20, 21; 20', 21'.

In Fig. 3 ist das Kantenprofil 26 unsymmetrisch trapezförmig dargestellt. Es könnte auch ein Beispiel ausgewählt werden, bei dem die Kanten beidseitig steil abfallen und nur im Fußbereich einseitig aufgrund von unsauberen Ätzprozessen eine Verbreiterung auftritt. Der TV-Autofokus wird in jedem Fall die Abbildung auf die kontrastreichste Abbildung der Oberfläche des Strukturelements einstellen. Auf diese Abbildung hat der aktuelle Verlauf des unsymmetrischen Teils des Kantenprofils nahezu keinen Einfluß. Es ergibt sich im Auflicht 18 daher ein im Vergleich zu Fig. 2 ähnliches Intensitätsprofil 27, aus dem die Kantenlagen 28, 29 und die Lagekoordinate 30 des Strukturelements 26 abzuleiten sind.

Im Durchlicht 23 ist jedoch allein der Fußbereich des Kantenprofils 26 für die Schattenbildung 31 und das auf den CCD-Elementen erzeugte Bild entscheidend. Es ergibt sich daher wiederum ein im wesentlichen symmetrisches Intensitätsprofil 32 mit nach rechts verschobener Kantenlage 29'. Damit resultiert zunächst eine größere Strukturbreite aus der Differenz der Kantenlagen und auch eine andere Lagekoordinate 30' für das Strukturelement 26. Die Differenz der Lagekoordinaten 30, 30' deutet also auf die Unsymmetrie des Kantenprofils 26 hin. Der Maskenhersteller ist somit in der Lage, seinen Herstellprozeß besser zu analysieren. Es ist ersichtlich, daß bei einem symmetrisch trapezförmigen Kantenprofil die Lagekoordinaten aus der Auflicht- und der Durchlichtmessung nicht unterschiedlich sind. Hier verändert sich lediglich die Aussage über die Strukturbreite. Auch das läßt eine Aussage über den Herstellprozeß zu. Die verwendeten Darstellungen der Kanten- und Intensitätsprofile sind schematisch und können insbesondere bei Strukturbreiten und Strukturabständen im Bereich der Lichtwellenlänge komplexer sein.

Die beschriebene Vergleichbarkeit der Meßdaten im Auflicht und im Durchlicht ist nur deswegen zulässig, weil sie in gleicher Lokalisierung des Substrats und mit denselben Abbildungs- und Auswertungsmitteln gewonnen werden. Erstmals wird die Zuordnung einer im Durchlicht gemessenen Strukturbreite zu einer absoluten Lageangabe für diese Struktur im Maskenkoordinatensystem möglich.

## Patentansprüche

1. Lagekoordination-Meßgerät zur Vermessung und Bestimmung der Lage von Strukturen (9) auf einem transparenten Substrat (8), wobei die Lage durch den Abstand einer Kante der Struktur (9) relativ zu einem Bezugspunkt definiert ist, mit einer Auflicht-Beleuchtungseinrichtung (10, 13), einer Abbildungs-Einrichtung (10) und einer Detektor-Einrichtung (14) für die abgebildeten Strukturen (9) und einem senkrecht und relativ zur optischen Achse (11) der Abbildungs-Einrichtung (10) interferometrisch (7) meßbar verschiebbarem Meßtisch (4) zur Aufnahme des Substrats (8), **dadurch gekennzeichnet, daß** der Meßtisch (4) als offener Rahmen mit einem Aufnahmerand für das Substrat (8) ausgebildet ist und unter dem Meßtisch (4) eine Durchlicht-Beleuchtungseinrichtung (15, 16) vorgesehen ist, deren optische Achse mit-der der Auflicht-Beleuchtungseinrichtung (10, 13) fluchtet.

2. Meßgerät nach Anspruch 1, **dadurch gekennzeichnet, daß** die Detektor-Einrichtung eine CCD-Kamera (14) ist.

3. Meßgerät nach Anspruch 1, **dadurch gekennzeichnet, daß** die Auflicht- und die Durchlicht-Beleuchtungseinrichtung wechselweise einschaltbar sind.

4. Verfahren zur Vermessung und Bestimmung der Lage von Strukturen auf einem transparenten Substrat mit Beleuchtung und Abbildung der Strukturen auf eine Detektor-Einrichtung und interferometrisch meßbarer Verschiebung des Substrats in einer Ebene senkrecht zur Abbildungsrichtung, unter Verwendung eines Lagekoordination-Meßgerätes nach dem Anspruch 1, **dadurch gekennzeichnet, dass** das Substrat wahlweise in Auflicht beleuchtet und dabei die Lage und die Strukturbreite mindestens eines Strukturelements bestimmt wird oder dass das Substrat im Durchlicht beleuchtet und dabei die Lage und die Strukturbreite des mindestens einen Strukturelements bestimmt wird, und Zuordnen einer gewonnen Lageangabe einer Struktur zur der zugehörigen, gemessenen Strukturbreite in ein und demselben Messgerät.

5. Verfahren nach Anspruch 4, **dadurch gekennzeichnet, daß** die Koordinaten der Strukturen sowohl bei Auflicht- als auch bei Durchlicht-Beleuchtung bestimmt werden.

6. Verfahren nach Anspruch 5, **dadurch gekennzeichnet, daß** die Kantenlagen der Strukturen bei Auflicht- und/oder Durchlicht-Beleuchtung für eine Strukturbreitenmessung ausgewertet werden.

## Claims

1. Positional coordinate measuring instrument for measuring and determining the position of structures (9) on a transparent substrate (8), the position being defined by the spacing of an edge of the structure (9) relative to a reference point, having a reflected light illumination system (10, 13), an imaging device (10) and a detector device (14) for the imaged structures (9) and a measuring table (4), which can be displaced perpendicularly and relative to the optical axis (11) of the imaging device (10) in an interferometrically (7) measurable fashion, for holding the substrate (8), **characterized in that** the measuring table (4) is designed as an open frame with a holding rim for the substrate (8), and there is provided below the measuring table (4) a transmitted light illumination system (15, 16) whose optical axis is aligned with the reflected light illumination system (10, 13).

2. Measuring instrument according to Claim 1, **characterized in that** the detector device is a CCD camera (14).

3. Measuring instrument according to Claim 1, **characterized in that** the reflected light illumination system and the transmitted light illumination system can be switched on alternately.

4. Method for measuring and determining the position of structures on a transparent substrate with illumination and imaging of the structures onto a detector device and interferometrically measurable displacement of the substrate in a plane perpendicular to the imaging direction, use being made of a positional coordination measuring instrument according to Claim 1, **characterized in that** the substrate is optionally illuminated in reflected light and in the process the position and structural width of at least one structural element are determined, or **in that** the substrate is illuminated in transmitted light, the position and structural width of the at least one structural element being determined in this case, and a positional datum obtained for a structure being assigned in one and the same measuring instrument to the associated, measured structural width.

5. Method according to Claim 4, **characterized in that** the coordinates of the structures are determined using illumination both with reflected light and with transmitted light.

6. Method according to Claim 5, **characterized in that** the edge positions of the structures in the case of reflected light and/or transmitted light illumination are evaluated for measuring structural width.

## Revendications

1. Appareil de mesure des coordonnées de position pour la mesure et la détermination de la position de structures (9) sur un substrat transparent (8), la position de la structure (9) étant définie par la distance entre l'un de ses bords par rapport à un point de référence, avec un dispositif (10, 13) d'éclairage en lumière incidente, un dispositif (10) de formation d'image et un dispositif (14) de détection de l'image des structures (9), ainsi qu'une table coulissante de mesure (4) pour la réception du substrat (8), qui peut être mesurée par interférométrie (7) dans la direction perpendiculaire et par rapport à l'axe optique (11) du dispositif (10) de formation d'image, **caractérisé en ce que** la table de mesure (4) est configurée comme cadre ouvert doté d'un bord de réception pour le substrat (8) et **en ce que** sous la table de mesure (4) est prévu un dispositif (15, 16) d'éclairage en lumière transmise dont l'axe optique est aligné sur celui du dispositif (10, 13) d'éclairage en lumière incidente.

2. Appareil de mesure selon la revendication 1, **caractérisé en ce que** le dispositif de détection est une caméra CCD (14).

3. Appareil de mesure selon la revendication 1, **caractérisé en ce que** le dispositif d'éclairage en lumière incidente et le dispositif d'éclairage en lumière transmise peuvent être branchés en alternance.

4. Procédé de mesure et de détermination de la position de structures sur un substrat transparent, par éclairage et formation de l'image des structures sur un dispositif de détection et déplacement, mesurable par interférométrie, du substrat dans un plan perpendiculaire à la direction de formation des images par recours à un appareil de mesure des coordonnées de position selon la revendication 1, **caractérisé en ce que** le substrat est éclairé sélectivement en lumière incidente, la position et la largeur d'au moins un élément structurel étant déterminées, ou **en ce que** le substrat est éclairé en lumière transmise, la position et la largeur d'au moins un élément structurel étant déterminées, l'association entre des données de position déterminées pour une structure et la largeur mesurée associée de la structure étant réalisée dans un seul et même appareil de mesure.

5. Procédé selon la revendication 4, **caractérisé en ce que** les coordonnées des structures sont déterminées tant par éclairage en lumière incidente que par éclairage en lumière transmise.

6. Procédé selon la revendication 5, **caractérisé en ce que** les positions des bords des structures lors de l'éclairage en lumière incidente et/ou de l'éclairage en lumière transmise sont évaluées pour mesurer la largeur des structures.
